# EUROPEAN PATENT SPECIFICATION

(11) **EP 2 492 700 B1**
(45) Date of publication and mention of the grant of the patent: **30.04.2014**
(21) Application number: 12157115.2
(22) Date of filing: 27.02.2012
(51) Int. Cl.: G01R 29/26, G01R 31/36, G01R 31/40

(54) **Test system and method of testing battery pack**
Testsystem und Verfahren zum Testen eines Batteriepacks
Système de test et procédé de test de bloc-batterie

(30) Priority: 28.02.2011 JP 2011042693
(43) Date of publication of application: 29.08.2012
(73) Proprietor: Kabushiki Kaisha Toshiba, Tokyo 105-8001 (JP)
(72) Inventor: Kuroda, Kazuto, Tokyo 105-8001 (JP); Kosugi, Shinichiro, Tokyo 105-8001 (JP); Shibuya, Nobuo, Tokyo 105-8001 (JP)
(74) Representative: Lind, Urban Arvid Oskar

(56) References cited:
- WO-A1-03/083498
- DE-A1-102009 020 911
- US-A1- 2003 206 021

## Description

### FIELD

Embodiments of the invention relate to a test system and a method of testing a battery pack.

### BACKGROUND

In recent years, rechargeable-battery systems each including a battery pack where a plurality of lithium-ion secondary cells are connected in series to one another have been proposed as rechargeable-battery systems for vehicles such as electric vehicles or for smart grids.

For the purpose of safely using a battery pack using lithium-ion secondary cells for a long period of time, the battery pack includes a voltage monitoring circuit to measure the voltages of the individual secondary cells and a discharging circuit to prevent the secondary cells from being charged non-uniformly. In addition, the battery pack using lithium-ion secondary cells includes a temperature monitoring circuit to measure the temperatures of the individual electric cells or the temperatures of individual groups of cells. For example, each single assembled battery includes approximately ten electric cells. A monitoring circuit in which a voltage monitoring circuit, a discharging circuit, and a temperature monitoring circuit are integrated (hereinafter, will be referred to as the "voltage temperature monitoring (VTM) circuit") is provided for each of the assembled batteries. The VTM circuits of the assembled batteries are connected to a battery management unit (BMU). The BMU exchanges information with the plurality of VTM circuits, and thereby manages and controls the entire battery pack

US2003206021 discloses a method and apparatus for creating a time-varying current excitation, delivering it to a system comprising at least one electronic or electrochemical element, and measuring and analyzing a time-varying electrical response developed within the system in response to the excitation.

A patent document (JP, P2009-303472A) discloses a test system for a power converter system capable of performing a noise test without using the power converter installed in the final product of the power converter system.

Ogasawara and others describe occurrence mechanisms of failures at the time of switching a voltage PWM inverter in a variable-speed AC drive, such as 1) the high-frequency leakage current; 2) the conducted and radiated electromagnetic interferences (EMIs); 3) the complex deterioration of motor-coil insulation; and 4) the shaft voltage and the bearing current in a motor, and also disclose the modeling of the occurrence mechanisms and a technique to reduce these failures (for more details, see Ogasawara et al., "Reduction of Leakage Current, Surge Voltage and Shaft Voltage in Variable-Speed AC Drives," IEEJ Transactions on Industry Applications, vol. 118, No. 9, pp.975-980).

The battery pack is connected directly to the inverter, which is the noise source, with no filters provided in between. When the noise immunity of a battery pack cannot be checked before the battery pack is set in a real machine, no failures can be detected before the battery pack is set in the real machine. Hence, the measures against the failures cannot be taken before the battery pack is set in the real machine. In addition, even when the noise immunity of a battery pack set in a particular real machine is checked, the check results are obtained only from the particular real machine where the battery pack is installed. Hence, it is difficult to prove the limit and the general properties of the immunity of the battery packs Problems in the noise immunity assessment of battery packs are also caused in noise immunity assessment of apparatuses other than battery packs

### BRIEF DESCRIPTION OF THE DRAWINGS

Fig. 1 is a diagram explaining an inverter noise generated when a battery pack is mounted on a vehicle;
Fig. 2 is a diagram schematically showing a configuration example of a test system according to an embodiment;
Fig. 3 is a diagram explaining an example of a method of testing a battery pack by means of the test system shown in Fig 2; and
Fig. 4 is a diagram showing schematically another configuration example of the test system according to the embodiment

### DETAILED DESCRIPTION

According to an embodiment, a test system configured to test a battery pack. The battery pack includes: an assembled battery including a plurality of secondary cells; a positive-electrode terminal electrically connected to a high-potential side of the assembled battery; a negative-electrode terminal electrically connected to a low-potential side of the assembled battery; a monitoring circuit configured to detect voltages of the plurality of secondary cells; a battery management unit configured to receive and output voltage data outputted from the monitoring circuit; a data-output terminal configured to output, to an outside of the battery pack, the voltage data outputted from the battery management unit; a first power-supply input terminal electrically connected to a positive electrode of a power supply; and a second power-supply input terminal electrically connected to a negative electrode of the power supply. The test system includes: the power supply; a high-frequency-voltage application unit including an output terminal and an earth terminal, and configured to output high-frequency voltage through the output terminal and the earth terminal; a splitter including an input terminal into which the high-frequency voltage outputted from the output terminal is inputted, and including a first output terminal and a second output terminal through which the high-frequency voltage inputted into the input terminal is outputted; a first coupling capacitor provided between the first output terminal and the positive-electrode terminal; a second coupling capacitor provided between the second output terminal and the negative-electrode terminal; a ground to which the earth terminal and the second power-supply input terminal are connected; and a data logger configured to record data outputted from the data-output terminal

A test system and a method of testing a battery pack according to embodiments will be described below with reference to the drawings.

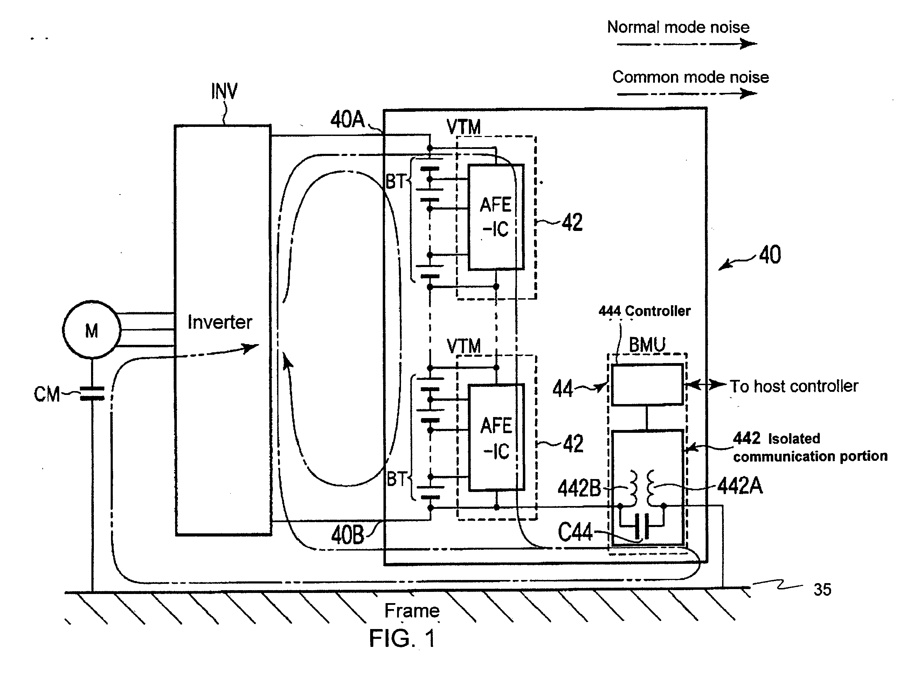

First of all, description is given of a vehicle, which is one of the application uses of the battery packs. Fig. 1 shows that the vehicle includes a battery pack 40, a motor M configured to drive axles, and an inverter INV configured to convert the DC voltage outputted from the battery pack 40 into a high, three-phase AC voltage for use in driving the motor M The inverter INV has three-phase output terminals that are connected respectively to the three-phase input terminals of the motor M. The revolutions of the motor M are transmitted to the drive wheels (not illustrated) via, for example, a differential gear unit (not illustrated) and axles (not illustrated). The battery pack 40 includes assembled batteries BT, and each assembled battery BT is provided with a monitoring circuit 42. In addition, the battery pack 40 is provided with a battery management unit 44

For the sake of safety, the high-voltage wirings that connect the inverter INV, the motor M, and the battery pack 40 to one another are insulated from a frame 35 of the vehicle. On the other hand, the battery management unit 44 includes a controller 444 to which power based on the frame 35 is supplied as is the case with other apparatuses in the vehicle. The battery management unit 44 or the monitoring circuit 42 is provided with a signal isolator. Through the signal isolator, power based on the frame 35 is supplied from the controller 444 of the battery management unit 44 to the monitoring circuit 42.

A coupling capacitor exists between the coils of the motor M and the frame 35. In addition, a coupling capacitor exists in the signal isolator provided either in the battery management unit 44 or in the monitoring circuit 42. It has been clear that a common-mode noise current generated by the operations of the inverter flows through the coupling capacitor. Beside the common-mode noise current, there is a current known as the normal-mode noise current that flows through the same route as the main circuit current flows

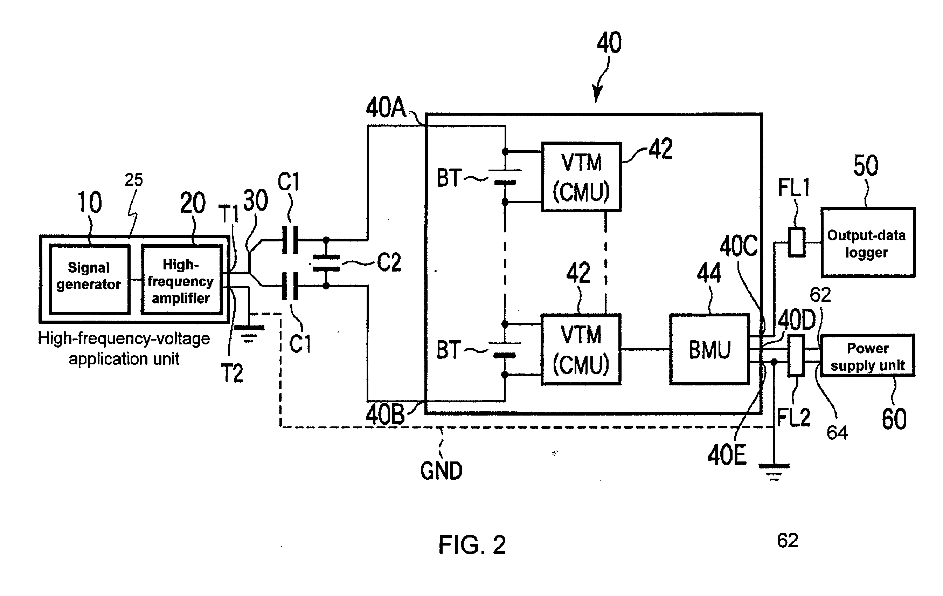

Fig. 1 shows an example of the inverter noise generated when the battery pack 40 is mounted on the vehicle The battery pack 40 includes a plurality of assembled batteries BT. The battery pack 40 also includes monitoring circuits (VTM circuits: Voltage Temperature Monitoring Circuits) 42 each of which monitors the voltages and the temperatures of the secondary cells included in the corresponding one of the assembled batteries BT. In addition, the battery pack 40 includes a battery management unit (BMU) 44 that manages the battery pack 40. Moreover, the battery pack 40 includes a positive-electrode terminal 40A, a negative-electrode terminal 40B, and a data-output terminal (not illustrated). The data-output terminal outputs voltage data and temperature data from the battery management unit 44 to a host controller (not illustrated). Furthermore, the battery pack 40 includes an unillustrated positive-side power-supply input terminal (first power-supply input terminal), and an unillustrated negative-side power-supply input terminal (second power-supply input terminal) that are used to supply power to the battery management unit 44 Note that a data-output terminal 40C, a positive-side power-supply input terminal 40D, and a negative-side power-supply input terminal 40E are shown in Fig. 2

The plurality of assembled batteries BT are connected in series to one another. The highest potential of the entire assembled batteries BT is electrically connected to the positive-electrode terminal 40A of the battery pack 40. The lowest potential of the entire assembled batteries BT is electrically connected to the negative-electrode terminal 40B of the battery pack 40. In this embodiment, the secondary cells included in the assembled battery BT are lithium-ion batteries.

The monitoring circuit 42 includes an analog front-end (AFE) circuit. The AFE circuit includes a voltage monitoring circuit (not illustrated), a temperature monitoring circuit (not illustrated), a discharging circuit (not illustrated), and a communication unit (not illustrated). The voltage monitoring circuit detects individually the voltages of the plurality of secondary cells included in the assembled battery BT. The temperature monitoring circuit detects the temperature of at least one of the plurality of secondary cells. The discharging circuit reduces the differences in the state of charging among the plurality of secondary cells. The communication unit outputs the values of the detected voltages and temperatures.

The battery management unit 44 includes a signal isolator 442 and the controller 444. The signal isolator 442 communicates with the monitoring circuit 42 and exchanges data on the voltages and temperatures of the secondary cells. In addition, the signal isolator 442 supplies power to the monitoring circuit 42.

The signal isolator 442 includes a transformer circuit. The transformer circuit includes a primary circuit 442A and a secondary circuit 442B. The power-supply voltage is supplied to the primary circuit 442A from a power-supply unit 60. The transformer circuit changes the voltage supplied to the primary circuit 442A into the changed voltage. The secondary circuit 442B outputs the voltage thus changed to the monitoring circuit 42. The primary circuit 442A is earthed to the frame 35 of the vehicle. The signal isolator 442 outputs the power-supply voltage to the monitoring circuit 42, and receives data on the voltages and the temperatures from the monitoring circuit 42. The primary circuit 442A and the secondary circuit 442B are electrically insulated from each other. A coupling capacitance C44 is generated between the primary circuit 442A and the secondary circuit 442B.

The controller 444 receives data on the voltages and the temperatures of the secondary cells from the signal isolator 442, and judges whether or not there is abnormality in the secondary cells. The controller 444 outputs, signals indicating that there is abnormality in the secondary cell, and data on the voltages and the temperatures of the secondary cells The controller 444 outputs the signals and the data through the data-output terminal 40C to the host controller (not illustrated)

The inverter INV is connected to the positive-electrode terminal 40A and the negative-electrode terminal 40B of the battery pack 40. The inverter INV converts the DC power supplied from the battery pack 40 into the three-phase AC power, and outputs the three-phase AC power to the motor M

The motor M is driven by the power supplied from the inverter INV. The power generated by the revolutions of the motor M is transmitted to the drive wheels of the vehicle via, for example, a differential gear unit (not illustrated) and axles (not illustrated). A coupling capacitor CM is generated between the coils of the motor M and the frame 35

Once the battery pack 40 is mounted on the vehicle, a route is formed starting from the inverter INV, to either assembled batteries BT or the monitoring circuit 42, then to the battery management unit 44, then to the frame 35, then to the motor M, and then back to inverter INV. The coupling capacitance C44 in the signal isolator 442 and the coupling capacitor CM that exists between the motor M and the frame 35 contribute to the formation of the above-mentioned route

In addition, a serial resonance circuit is formed by the coupling capacitor CM and the induction component that is parasitic in the wirings connecting the constituent elements to one another. A common-mode noise current generated by the operations of the inverter INV is transformed to a current that contains a large high-frequency component by the serial resonance circuit, and the transformed current flows through the above-described route. Beside the common-mode noise current, there exists a normal-mode noise current that flows through the same route as the main circuit current flows

The common-mode noise current contains more high-frequency component, and therefore tends to flow not through the assembled batteries BT with a larger high-frequency impedance but through the monitoring circuit 42. Hence, the common-mode noise current flows through the inverter INV and the monitoring circuit 42 towards the secondary circuit 442B in the signal isolator 442. The common-mode noise current flows through the coupling capacitance C44 towards the primary circuit 442A. Then, the common-mode noise current flows through the frame 35, the coupling capacitor CM and the motor M, and returns to the inverter INV

The monitoring circuit 42 is provided with a sophisticated circuit capable of detecting a change in a voltage of 0.1 V or less. In addition, each monitoring circuit 42 communicates with another monitoring circuit 42 or with the battery management unit 44. Hence, when the common-mode noise current flows through the monitoring circuit 42, the fluctuations of voltage caused by the unbalanced current routes sometimes break the circuits in the monitoring circuit 42 or cut off the communications. When such problems occur, the data on the voltages and the temperatures detected by the monitoring circuit 42 become less reliable, or in the worst cases, the voltage detection and/or the temperature detection by the monitoring circuit 42 become impossible. Consequently, it is difficult to secure the safety of the battery pack 40

The common-mode noise current has various frequencies depending upon the configuration of the entire system, but in many cases, the principal frequency component ranges from approximately 1 MHz to 100 MHz In addition, the amplitude (peak voltage) of the common-mode noise is equivalent to the switching voltage of the inverter INV (i.e. the output voltage of the battery)

The test system of this embodiment is capable of performing a quantitative assessment of the immunity that each battery pack 40 has against the common-mode noise current even before the battery pack 40 is mounted on a vehicle.

Fig. 2 schematically shows a configuration example of the test system of this embodiment. The test system includes a high-frequency-voltage application unit 25, which includes a signal generator 10 and a high-frequency amplifier 20. The test system also includes a splitter 30, two coupling capacitors C1, C1, an inverter-simulating capacitor C2, an output-data logger 50, and the power-supply unit 60. The test object is the battery pack 40 with an identical configuration to the one shown in Fig. 1.

The signal generator 10 is capable of outputting signals with various frequencies and amplitudes. The output terminal of the signal generator 10 is electrically connected to the input terminal of the high-frequency amplifier 20.

The high-frequency amplifier 20 amplifies the high-frequency component of the inputted signal, and outputs the amplified signal. A hot-side output (output terminal) T1 of the high-frequency amplifier 20 is electrically connected to the input terminal of the splitter (splitting means) 30. A cold-side output (earth terminal)' T2 of the high-frequency amplifier 20 is electrically connected to the ground GND.

The signal generator 10 and the high-frequency amplifier 20 together form the high-frequency-voltage application unit 25. The high-frequency-voltage application unit 25 has an output terminal and an earth terminal, and outputs high-frequency voltages from the output terminal and the earth terminal.

The splitter 30 has a single input terminal, and two output terminals (a first output terminal and a second output terminal). The splitter 30 splits the signal received by the single input terminal, and outputs the split signals individually from the two output terminals. The input terminal of the splitter 30 is connected to the output of the high-frequency amplifier 20. The two output terminals of the splitter 30 are electrically connected respectively, through the coupling capacitors C1, C1, to the positive-electrode terminal 40A and the negative-electrode terminal 40B of the test object, i.e. the battery pack 40.

Each coupling capacitor C1 has a self-resonant frequency that is, for example, sufficiently higher than the frequencies of the signals outputted from the high-frequency amplifier 20. Film capacitors or ceramic capacitors are used as the coupling capacitors C1, C1. It is desirable that each coupling capacitor C1 has a capacitance that is ten times or more than the capacitance of the ground coupling capacitor of the main circuit of the battery pack 40 so that the coupling capacitors C1, C1 do not affect the measurement results.

The inverter-simulating capacitor C2 is connected between the positive-electrode terminal 40A and the negative-electrode terminal 40B (i.e. between the main-circuit outputs) of the battery pack 40. This is because when the battery pack 40 is mounted on a vehicle, a capacitor is sometimes connected to the input portion of the inverter INV. The inverter-simulating capacitor C2 simulates this capacitor. Hence, the inverter-simulating capacitor C2 is not required to be connected between the main-circuit outputs of the battery pack 40. Whether or not the inverter-simulating capacitor C2 is to be used can be determined in accordance with the configuration of the vehicle that the battery pack 40 is to be mounted on.

The power-supply unit 60 supplies power to the battery management unit 44 of the battery pack 40. The power-supply unit 60 includes, for example, a lead-acid battery with a rated voltage of 12 V. The positive-side power-supply input terminal 40D of the battery management unit 44 is connected to a positive electrode 62 of the power-supply unit 60. The negative-side power-supply input terminal 40E, on the other hand, is connected to the ground GND and a negative electrode 64 of the power-supply unit 60.

The ground GND to which the negative-side power-supply input terminal 40E of the battery management unit 44 is connected and the ground GND to which the cold-side output (earth terminal) T2 of the high-frequency amplifier 20 is earthed are metal plates, such as copper plates and aluminum plates. The metal plates are earthed to the ground. The negative-side power-supply input terminal 40E of the battery management unit 44 and the cold-side output (earth terminal) T2 of the high-frequency amplifier 20 are connected, with a low impedance, to each other by means of the ground GND.

To prevent the power-supply unit 60 from affecting the measurement results, a filter FL2 configured to block high-frequency currents may preferably be provided in the output wiring of the power-supply unit 60. When, however, there is a wiring used in the communications performed by the battery management unit 44 to and from the outside, a filter configured to block high-frequency currents is provided in the route of the wiring. The use of such filters can prevent the constituent elements outside of the battery pack 40 from affecting the measurement results. In addition, the use of such filters can also prevent the external apparatuses from becoming an abnormal state due to the high-frequency currents that would otherwise flow into the external apparatuses. In the test system shown in Fig. 2, a wiring used in the communications between the battery management unit 44 and the output-data logger 50 is connected to the data-output terminal 40C, and a filter FL1 configured to block high-frequency currents is provided in the route of the wiring

The output-data logger 50 is a data logger configured to record the data on the voltages and the temperatures of the secondary cells outputted from the battery management unit 44 through the data-output terminal 40C during the assessment test. The target of the assessment, which is the immunity of the battery pack 40, is judged on the basis of whether or not there are abnormal values of the voltages and the temperature of the secondary cells in the data recorded in the output-data logger 50 after the assessment test is finished.

The above-described configuration of the test system simulates the route through which the common-mode noise current flows when the battery pack 40 is mounted on a vehicle. Then, when the high-frequency-voltage application unit 25 applies, to the battery pack 40, a voltage equivalent to the noise voltage, a high-frequency current corresponding to the desired common-mode noise current can be supplied to the battery pack 40.

Next, description is given of a testing method by which the immunity of each battery pack 40 against the common-mode noise current is assessed by means of the above-described test system. Note that the chain double-dashed line in Fig. 1 indicates the flow of the common-mode noise current.

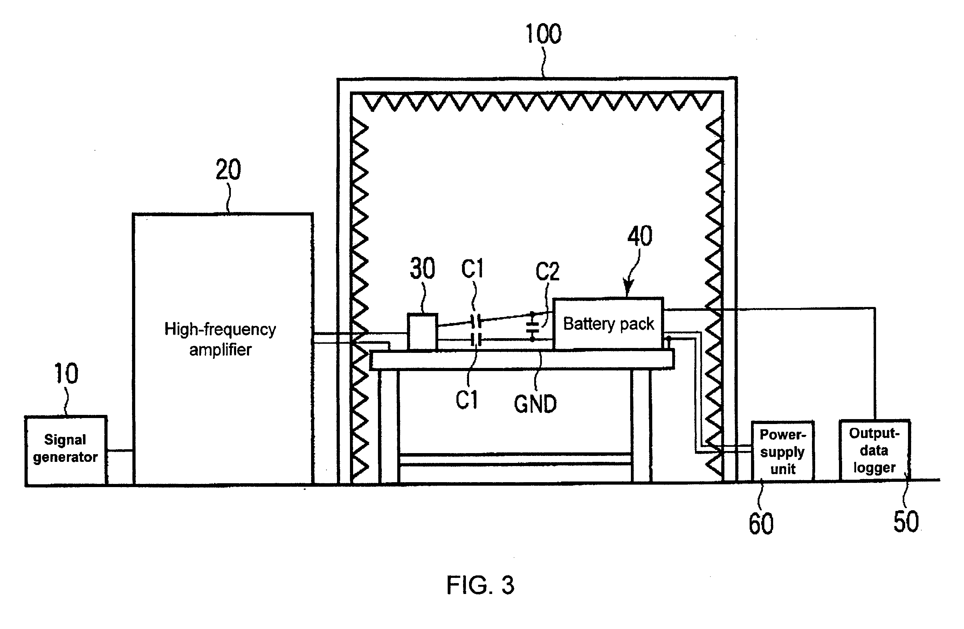

Fig. 3 shows an example of an environment where the test system is installed when the assessment test is performed. In the assessment test of the common-mode noise-current immunity by use of the above-described test system, the battery pack 40 (test object), the splitter 30, the coupling capacitors C1, C1, the inverter-simulating capacitor C2, and the ground GND are provided in an anechoic chamber 100. On the other hand, the signal generator 10, the high-frequency amplifier 20, the power-supply unit 60, and the output-data logger 50 are provided outside of the anechoic chamber 100. This is because with the application of a high-frequency current to the battery pack 40, the wirings in the battery pack 40 act as an antenna to radiate radio waves corresponding to the applied power, and the radio waves may damage the high-frequency amplifier 20. Accordingly, at least the battery pack 40 has to be in the anechoic chamber 100 during the test.

The battery pack 40 is placed on a metal plate, such as a copper plate and an aluminum plate, that is provided in the anechoic chamber 100 and that serves as the ground GND. The negative-side power-supply input terminal 40E of the battery management unit 44 is earthed to the ground GND. The wiring extending from the positive electrode 62 of the power-supply unit 60 into the anechoic chamber 100 and the wiring extending from the negative electrode 64 of the power-supply unit 60 into the anechoic chamber 100 are connected to the battery pack 40. The positive-side power-supply input terminal 40D of the battery management unit 44 is electrically connected to the positive electrode 62 whereas the negative-side power-supply input terminal 40E of the battery management unit 44 is electrically connected to the negative electrode 64.

A communication line is connected to the data-output terminal 40C of the battery pack 40. The communication line is used to output signals from the battery pack 40 to the output data logger 50 that is outside of the anechoic chamber 100

The positive-electrode terminal 40A and the negative-electrode terminal 40B of the battery pack 40 are electrically connected through the wirings respectively, via the coupling capacitors C1, C1, to the two output terminals of the splitter 30. The inverter-simulating capacitor C2 is connected between the positive-electrode terminal 40A and the negative-electrode terminal 40B of the battery pack 40.

The hot-side output (output terminal) of the high-frequency amplifier 20 is connected to the input terminal of the splitter 30 in the anechoic chamber 100 by means of the inner conductor of a coaxial cable The cold-side output (earth terminal) of the high-frequency amplifier 20 is earthed to the ground GND in the anechoic chamber 100 by means of the outer conductor of the coaxial cable

With the test system arranged in the above-described way, adjusted signals from the signal generator 10 are amplified by the high-frequency amplifier 20, and the amplified output is applied to the battery pack 40 continuously for a predetermined period of time. In this way, the test system tests the battery pack 40 concerning whether or not the battery pack 40 has immunity against noise in broadband frequencies. Note that the amplitude of the output signal of the signal generator 10 is adjusted before the test by connecting a terminating resistor to the output of the high-frequency amplifier 20 (i.e. to the inputs of the coupling capacitors C1, C1). The adjustment of the amplitude is performed by using either a wattmeter or a voltmeter so that a predetermined amplitude of voltage can be obtained at a predetermined frequency. In the test, the measurement is performed with the adjusted amplitude of the output of the signal generator 10. The waveform used in the test is typically obtained by sweeping, at a predetermined sweeping speed, the frequency of a sinusoidal wave with a frequency within a predetermined frequency range. Alternative waveforms that may be used instead are ones with modulated amplitudes and/or pulse widths that are commonly used in an electromagnetic interference test.

A high-frequency current corresponding to a predetermined common-mode noise current is made to flow through the battery pack 40 continuously for a predetermined period of time, and then judgment is performed to determine whether the values of the voltages and the temperatures in the data recorded in the output-data logger 50 are normal or abnormal. With the judgment result, the immunity of the battery pack 40 against the common-mode noise current is assessed.

As described above, by using the test system, the immunity of the battery pack 40 against the common-mode noise current can be tested before the battery pack 40 is actually mounted on a vehicle. Accordingly, before the battery pack 40 is actually mounted on a vehicle, some measures can be taken to counter the problems caused by the common-mode noise current In addition, the test system enables a quantitative measurement of noise immunity independent of the characteristics of the inverter INV and the like

Next, a test to assess the immunity against the normal-mode noise current is described with reference to the drawings. Note that in the following description, the same constituent elements as those in the above-mentioned test system are denoted by the same reference numerals and description thereof is omitted

Fig. 1 shows an example of an inverter noise generated when the battery pack 40 is actually mounted on a vehicle. The normal-mode noise current is generated by the resonance of parasitic capacitance and parasitic inductance of the motor coils and the switching element at the time of switching. The normal-mode noise current is a noise current flowing through the same route as the main circuit current flows. The dashed line in Fig. 1 indicates the flow of the normal-mode noise current

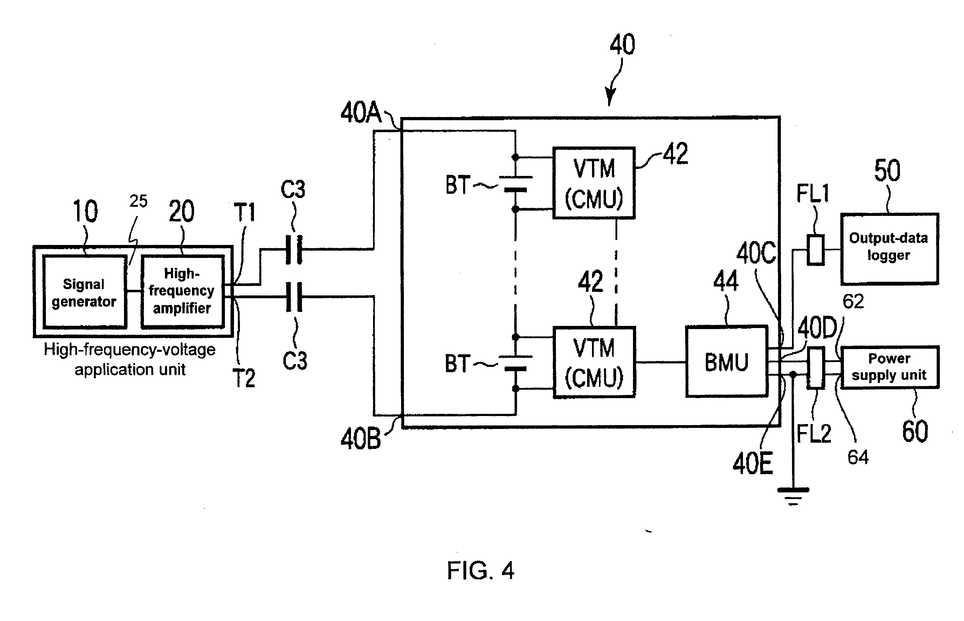

Fig. 4 illustrates another configuration example of the test system according to the embodiment. The test system of this embodiment includes a high-frequency-voltage application unit 25, which includes a signal generator 10 and a high-frequency amplifier 20. In addition, the test system also includes two coupling capacitors C3, C3, an output-data logger 50, and a power-supply unit 60. The test object, i.e. a battery pack 40, has a configuration identical to the configuration of the battery pack 40 shown in Fig. 1.

In this test system, the noise generated by the switching of the inverter INV is replaced with a high-frequency voltage generated by the high-frequency-voltage application unit 25 that includes the signal generator 10 and the high-frequency amplifier 20. The high-frequency-voltage application unit 25 has an output terminal and an earth terminal. The high-frequency-voltage application unit 25 outputs high-frequency voltages through the output terminal and through the earth terminal.

The output terminal of the signal generator 10 is connected to the input terminal of the high-frequency amplifier 20. The hot-side output (output terminal) T1 of the high-frequency amplifier 20 is connected to a positive-electrode terminal 40A of the battery pack 40 via one of the two coupling capacitors C3, C3. The cold-side output (earth terminal) T2 of the high-frequency amplifier 20 is connected to a negative-electrode terminal 40B of the battery pack 40 via the other one of the two coupling capacitors C3, C3.

The coupling capacitors C3, C3 are, for example, film capacitors or ceramic capacitors. Each coupling capacitor C3 has a self-resonant frequency sufficiently higher than the frequency outputted from the high-frequency amplifier 20. Each coupling capacitor C3 has a capacitance determined in a manner that the absolute value of the impedance is not larger than 50 in the range of measured frequency and thereby the coupling capacitor C3 does not affect the measurement results.

The power-supply unit 60 supplies power to a battery management unit 44 of the battery pack 40. The power-supply unit 60 includes, for example, a lead-acid battery with a rated voltage of 12 V. The battery management unit 44 has a positive-side power-supply input terminal 40D connected to a positive electrode 62 of the power-supply unit 60. The battery management unit 44 also has a negative-side power-supply input terminal 40E earthed to the ground and connected to a negative electrode 64 of the power-supply unit 60.

To prevent the power-supply unit 60 from affecting the measurement results, a filter FL2 configured to block high-frequency currents may preferably be provided in the output wiring of the power-supply unit 60. When, however, there is a wiring used in the communications performed by the battery management unit 44 to and from the outside, a filter configured to block high-frequency currents is provided in the route of the wiring. The use of such filters can prevent the constituent elements outside of the battery pack 40 from affecting the measurement results. In addition, the use of such filters can also prevent the external apparatuses from becoming an abnormal state due to the high-frequency currents that would otherwise flow into the external apparatuses. In the test system shown in Fig. 4, a wiring used in the communications between the battery management unit 44 and the output-data logger 50 is connected to the data-output terminal 40C, and a filter FL1 configured to block high-frequency currents is provided in the route of the wiring.

The output-data logger 50 is a data logger configured to record the signals containing the data on the voltages and the temperatures of the secondary cells outputted from the battery management unit 44 through the data-output terminal 40C during the assessment test. The target of the assessment, which is the immunity of the battery pack 40, is judged on the basis of whether or not there are abnormal values of the voltages and the temperature of the secondary cells in the data recorded in the output-data logger 50 after the assessment test is finished

Next, description is given of a testing method by which the immunity of each battery pack 40 against the normal-mode noise current is assessed by means of the above-described test system. Note that in the assessment test on the immunity against the normal-mode noise current, the same constituent elements as those in the installation environment shown in Fig 3 are denoted by the same reference numerals and description thereof is omitted

In the assessment test of the normal-mode noise-current immunity by use of the above-described test system, the battery pack 40 (test object), and the coupling capacitors C3, C3 are provided in an anechoic chamber 100. On the other hand, the signal generator 10, the high-frequency amplifier 20, the power-supply unit 60, and the output-data logger 50 are provided outside of the anechoic chamber 100. This is because with the application of a high-frequency current to the battery pack 40, the wirings in the battery pack 40 act as an antenna to radiate radio waves corresponding to the applied power, and the radio waves may damage the high-frequency amplifier 20. Accordingly, at least the battery pack 40 has to be in the anechoic chamber 100 during the test.

The battery pack 40 is placed on a metal plate, such as a copper plate and an aluminum plate, that is provided in the anechoic chamber 100 and that serves as the ground. The negative-side power-supply input terminal 40E of the battery management unit 44 is earthed to the ground. The wiring extending from the positive electrode 62 of the power-supply unit 60 into the anechoic chamber 100 and the wiring extending from the negative electrode 64 of the power-supply unit 60 into the anechoic chamber 100 are connected to the battery pack 40. The positive-side power-supply input terminal 40D of the battery management unit 44 is electrically connected to the positive electrode 62 whereas the negative-side power-supply input terminal 40E of the battery management unit 44 is electrically connected to the negative electrode 64.

A communication line is connected to the data-output terminal 40C of the battery pack 40, and is used to output signals to the output-data logger 50 that is outside of the anechoic chamber 100.

The positive-electrode terminal 40A of the battery pack 40 is electrically connected to the output terminal T1 of the high-frequency-voltage application unit 25 via one of the coupling capacitors C3, C3 by means of a wiring. The negative-electrode terminal 40B of the battery pack 40, on the other hand, is electrically connected to the earth terminal T2 of the high-frequency-voltage application unit 25 via the other one of the coupling capacitors C3, C3 by means of a wiring

With the test system arranged in the above-described way, adjusted signals from the signal generator 10 are amplified by the high-frequency amplifier 20, and the amplified output is applied to the battery pack 40 continuously for a predetermined period of time. In this way, the test system tests the battery pack 40 concerning whether or not the battery pack 40 has immunity against noise in broadband frequencies. Note that the amplitude of the output signal of the signal generator 10 is adjusted before the test by connecting a terminating resistor to the output of the high-frequency amplifier 20 (i.e. to the inputs of the coupling capacitors C3, C3). The adjustment of the amplitude is performed by using either a wattmeter or a voltmeter so that a predetermined amplitude of voltage can be obtained at a predetermined frequency. In the test, the measurement is performed with the adjusted amplitude of the output of the signal generator 10. The waveform used in the test is typically obtained by sweeping, at a predetermined sweeping speed, the frequency of a sinusoidal wave with a frequency within a predetermined frequency range. Alternative waveforms that may be used instead are ones with modulated amplitudes and/or pulse widths that are commonly used in an electromagnetic interference test.

A high-frequency current corresponding to a predetermined normal-mode noise current is made to flow through the battery pack 40 continuously for a predetermined period of time, and then judgment is performed to determine whether the values of the voltages and the temperatures of the secondary cells in the data recorded in the output-data logger 50 are normal or abnormal. With the judgment result, the immunity of the battery pack 40 against the normal-mode noise current is assessed

As described above, in the test system of this embodiment, the high-frequency-voltage application unit 25 including the signal generator 10 and the high-frequency amplifier 20 is used as a noise source. The signals outputted from the high-frequency-voltage application unit 25 can be reproduced repeatedly and are measurable quantitatively. Hence, the assessment of the inverter-noise immunity of the battery pack 40 is quantitative and ïs applicable universally. In addition, the test system can assess the immunity against the common-mode noise and the immunity against the normal-mode noise with a load simulating the inverter INV being connected to the battery. Hence, the test system allows the influence caused by noise similar to the inverter noise to be assessed in advance without performing a test where the battery pack 40 is connected to an inverter in a real machine.

Accordingly, the embodiment can provide the test system and the method of testing secondary-cell devices capable of quantitatively assessing the noise immunity of the apparatus to be connected to an inverter

## Claims

1. A test system configured to test a battery pack (40) including: an assembled battery (BT) including a plurality of secondary cells; a positive-electrode terminal (40A) electrically connected to a positive electrode side of the assembled battery; a negative-electrode terminal (40B) electrically connected to a negative electrode side (40B) of the assembled battery; a monitoring circuit (42) configured to detect voltages of the plurality of secondary cells; a battery management unit (44) configured to receive and output voltage data outputted from the monitoring circuit (42); a data-output terminal (40C) configured to output, to an outside of the battery pack, the voltage data outputted from the battery management unit (42); a first power-supply input terminal (40D) electrically connected to a positive electrode (62) of a power supply (60); and a second power-supply input terminal (40E) electrically connected to a negative electrode (64) of the power supply (60);
**characterized in that** the test system comprises:
the power supply (60);
a high frequence voltage application unit (25) including an output terminal (T1) and an earth terminal (T2), and is configured to output a voltage through the output terminal (T1) and the earth terminal (T2);
a splitter (30) including an input terminal into which the high frequency voltage outputted from the output terminal (T1) is inputted, and including a first output terminal and a second output terminal through which the high frequency voltage inputted into the input terminal is outputted;
a first coupling capacitor (C1) provided between the first output terminal (30) and the positive-electrode terminal (40A);
a second coupling capacitor (C1) provided between the second output terminal (30) and the negative-electrode terminal (40B);
a ground to which the earth terminal (T2) and the second power-supply input terminal (40E) are connected; and
a data logger (50) configured to record data outputted from the data-output terminal (40C).

2. The test system according to claim 1, further comprising a capacitor (C2) connected between the positive-electrode terminal (40A) and the negative-electrode terminal (40B).

3. The test system according to claim 1, further comprising: a first filter (FL1) inserted in a wiring to be used in communications between the battery pack (40) and the data logger (50), and configured to block a high-frequency current; and
a second filter (FL2) inserted in a wiring to be used to supply power from the power supply (60) to the battery pack (40), and configured to block a high-frequency current.

4. The test system according to claim 1, wherein the monitoring circuit (42) detects the voltage of each of the plurality of secondary cells.

5. A method of testing a battery pack comprising:
forming a route through which a noise current flows by connecting an output terminal (T1) of a high frequency voltage application unit (25) and a positive-electrode terminal (40A) of a battery pack (40) to each other via a first coupling capacitor (C1), by connecting an earth terminal (T1) of the high frequency voltage application unit (25) and a negative-electrode terminal (40B) of the battery pack (40) to each other via a second coupling capacitor (C1), by connecting a first power-supply input terminal (40D) of the battery pack (40) and a positive electrode (62) of the power supply (60) to each other, by connecting a second power-supply input terminal (40E) of the battery pack (40) and a negative electrode (64) of the power supply (60) to each other, by connecting the second power-supply input terminal (64) and the earth terminal (T2) of the high frequency voltage application unit (25) to a ground, and by connecting a capacitor (C2) between the positive-electrode terminal (40A) and the negative-electrode terminal (40B);
connecting a data-output terminal (40C) of the battery pack (40) and a data logger (50) to each other by means of a communication line;
outputting a high frequency voltage to the output terminal (T1) and the earth terminal (T2) of the high frequency voltage application unit (25) for a predetermined period of time; and
recording, in the data logger (50), voltage data of secondary cells outputted from the battery pack (40) during the predetermined period of time.

## Patentansprüche

1. Testsystem, konfiguriert zum Testen eines Batteriesatzes (40), umfassend: eine zusammengebaute Batterie (BT), die eine Vielzahl sekundärer Zellen umfasst; einen positiven Elektrodenanschluss (40A), der elektrisch an eine positive Elektrodenseite der zusammengebauten Batterie angeschlossen ist; einen negativen Elektrodenanschluss (40B), der elektrisch an eine negative Elektrodenseite (40B) der zusammengebauten Batterie angeschlossen ist; eine Überwachungsschaltung (42), die konfiguriert ist, um Spannungen der Vielzahl von sekundären Zellen zu erkennen; eine Batterieverwaltungseinheit (44), die konfiguriert ist, um Spannungsdaten zu empfangen und auszugeben, die von der Überwachungsschaltung (42) ausgegeben werden; einen Datenausgangsanschluss (40C), der konfiguriert ist, um an einen Außenbereich des Batteriesatzes die Spannungsdaten auszugeben, die von der Batterieverwaltungseinheit (42) ausgegeben werden; einen ersten Energieversorgungs-Eingangsanschluss (40D), der elektrisch an eine positive Elektrode (62) einer Energieversorgung (60) angeschlossen ist; und einen zweiten Energieversorgungs-Eingangsanschluss (40E), der elektrisch an eine negative Elektrode (64) der Energieversorgung (60) angeschlossen ist;
**dadurch gekennzeichnet, dass** das Testsystem Folgendes umfasst:
die Energieversorgung (60);
eine Einheit (25) zum Anlegen einer Hochfrequenzspannung, die einen Ausgangsanschluss (T1) und einen Erdungsanschluss (T2) umfasst und konfiguriert ist, um eine Spannung über den Ausgangsanschluss (T1) und den Erdungsanschluss (T2) auszugeben;
einen Verteiler (30), der einen Eingangsanschluss umfasst, in den die Hochfrequenzspannung eingegeben wird, die von dem Ausgangsanschluss (T1) ausgegeben wird, und der einen ersten Ausgangsanschluss und einen zweiten Ausgangsanschluss umfasst, über welche die Hochfrequenzspannung ausgegeben wird, die in den Eingangsanschluss eingegeben wird;
einen ersten Koppel kondensator (C1), der zwischen dem ersten Ausgangsanschluss (30) und dem positiven Elektrodenanschluss (40A) bereitgestellt wird;
einen zweiten Koppel kondensator (C1), der zwischen dem zweiten Ausgangsanschluss (30) und dem negativen Elektrodenanschluss (40B) bereitgestellt wird;
eine Masse, an die der Erdungsanschluss (T2) und der zweite Energieversorgungs-Eingangsanschluss (40E) angeschlossen sind; und
einen Messwerterfasser (50), der konfiguriert ist, um Daten aufzuzeichnen, die von dem Datenausgangsanschluss (40C) ausgegeben werden.

2. Testsystem nach Anspruch 1, ferner umfassend einen Kondensator (C2), der zwischen dem positiven Elektrodenanschluss (40A) und dem negativen Elektrodenanschluss (40B) angeschlossen ist.

3. Testsystem nach Anspruch 1, ferner umfassend:
ein erster Filter (FL1), der in eine Verkabelung eingefügt ist, die bei Kommunikationen zwischen dem Batteriesatz (40) und dem Messwerterfasser (50) zu verwenden ist, und das konfiguriert ist, um einen Hochfrequenzstrom zu blockieren; und
ein zweiter Filter (FL2), der in einer Verkabelung eingefügt wird, die zu verwenden ist, um Energie von der Energieversorgung (60) an den Batteriesatz (40) zu liefern, und das konfiguriert ist, um einen Hochfrequenzstrom zu blockieren.

4. Testsystem nach Anspruch 1, wobei die Überwachungsschaltung (42) die Spannung jeder der Vielzahl von sekundären Zellen ermittelt.

5. Verfahren zum Testen eines Batteriesatzes, umfassend folgende Schritte:
Bilden einer Strecke, auf der ein Rauschstrom fließt, indem ein Ausgangsanschluss (T1) einer Einheit (25) zum Anlegen einer Hochfrequenzspannung und ein positiver Elektrodenanschluss (40A) eines Batteriesatzes (40) über einen ersten Koppel kondensator (C1) aneinander angeschlossen werden, indem ein Erdungsanschluss (T1) der Einheit (25) zum Anlegen einer Hochfrequenzspannung und ein negativer Elektrodenanschluss (40B) des Batteriesatzes (40) über einen zweiten Koppelkondensator (C1) aneinander angeschlossen werden, indem ein erster Energieversorgungs-Eingangsanschluss (40D) des Batteriesatzes (40) und eine positive Elektrode (62) der Energieversorgung (60) aneinander angeschlossen werden, indem ein zweiter Energieversorgungs-Eingangsanschluss (40E) des Batteriesatzes (40) und eine negative Elektrode (64) der Energieversorgung (60) aneinander angeschlossen werden, indem der zweite Energieversorgungs-Eingangsanschluss (64) und der Erdungsanschluss (T2) der Einheit (25) zum Anlegen einer Hochfrequenzspannung an Masse angeschlossen werden, und indem ein Kondensator (C2) zwischen dem positiven Elektrodenanschluss (40A) und dem negativen Elektrodenanschluss (40B) angeschlossen wird;
Anschließen eines Datenausgangsanschlusses (40C) des Batteriesatzes (40) und eines Messwerterfassers (50) aneinander anhand einer Kommunikationsleitung;
Ausgeben einer Hochfrequenzspannung an den Ausgangsanschluss (T1) und den Erdungsanschluss (T2) der Einheit (25) zum Anlegen einer Hochfrequenzspannung während eines vorbestimmten Zeitraums; und
Aufzeichnen in dem Messwerterfasser (50) der Spannungsdaten von sekundären Zellen, die von dem Batteriesatz (40) während des vorbestimmten Zeitraums ausgegeben werden.

## Revendications

1. Système de test configuré pour tester des piles (40) y compris : des piles assemblées (BT) y compris une pluralité de piles secondaires ; une borne d'électrode positive (40A) connectée de manière électrique à une extrémité de l'électrode positive des piles assemblées ; une borne d'électrode négative (40B) connectée de manière électrique à une extrémité de l'électrode négative (40B) des piles assemblées ; un circuit de surveillance (42) configuré pour détecter les tensions de la pluralité des piles secondaires ; une unité de gestion de piles (44) configurée pour recevoir des données de tension de sortie délivrées en sortie par le circuit de surveillance (42) ; une borne de sortie de données (40C) configurée pour délivrer, à l'extérieur des piles, les données de tension provenant de l'unité de circuit de surveillance (42) ; une première borne d'entrée d'une source d'alimentation électrique (40D) reliée électriquement à une électrode positive (62) d'une source d'alimentation (60) ; et une deuxième borne d'entrée d'une source d'alimentation électrique (40E) reliée électriquement à une électrode négative (64) de la source d'alimentation (60) ;
**caractérisé en ce que** le système de test comprend : la source d'alimentation (60) ;
une unité d'application de tension à haute fréquence (25) comprenant une borne de sortie (T1) et une borne de mise à la terre (T2), et configurée pour délivrer en sortie une tension à travers la borne de sortie (T1) et la borne de mise à la terre (T2) ;
un séparateur (30) comprenant une borne d'entrée à laquelle est appliquée la tension à haute fréquence émise à la borne de sortie (T1), et comprenant une première borne de sortie et une deuxième borne de sortie à travers lesquelles la tension à haute fréquence appliquée à la borne d'entrée est délivrée en sortie ;
un premier condensateur de couplage (C1) prévu entre la première borne de sortie (30) et la borne d'électrode positive (40A) ;
un second condensateur de couplage (C1) prévu entre la seconde borne de sortie (30) et la borne d'électrode négative (40B) ;
une terre à laquelle la borne de mise à la terre (T2) et la seconde borne d'entrée de la source d'alimentation (40E) sont reliées ; et
un enregistreur de données (50) configuré pour enregistrer des données émises en sortie depuis le terminal de sortie de données (40C).

2. Système de test selon la revendication 1, comprenant en outre un condensateur (C2) connecté entre la borne d'électrode positive (40A) et la borne d'électrode négative (40B).

3. Système de test selon la revendication 1, comprenant en outre :
un premier filtre (FL1) inséré dans un câblage à utiliser lors des communications entre les piles (40) et l'enregistreur de données (50), et configuré pour bloquer un courant à haute fréquence ; et
un second filtre (FL2) inséré dans un câblage à utiliser pour transférer l'énergie de la source d'alimentation (60) vers les piles (40), et configuré pour bloquer un courant à haute fréquence.

4. Système de test selon la revendication 1, dans lequel le circuit de surveillance (42) détecte la tension de chacune des pluralités de piles secondaires.

5. Procédé pour tester des piles comprenant :
la formation d'une voie à travers laquelle un courant de bruit circule en reliant une borne de sortie (T1) d'une unité d'application de tension à haute fréquence (25) et une borne d'électrode positive (40A) des piles (40) l'une à l'autre par l'intermédiaire d'un premier condensateur de couplage (C1), en reliant une borne de mise à la terre (T1) de l'unité d'application de tension à haute fréquence (25) et une borne d'électrode négative (40B) des piles (40) l'une à l'autre par l'intermédiaire d'un second condensateur de couplage (C1), en reliant une première borne d'entrée de l'alimentation électrique (40D) des piles (40) et une électrode positive (62) de l'alimentation électrique (60) l'une à l'autre, en reliant une seconde borne d'entrée de l'alimentation électrique (40E) des piles (40) et une électrode négative (64) de l'alimentation électrique (60) l'une à l'autre, en reliant la deuxième borne d'entrée de l'alimentation électrique (64) et la borne de mise à la terre (T2) de l'unité d'application de la tension à haute fréquence (25) à une terre, et en reliant un condensateur (C2) entre la borne d'électrode positive (40A) et la borne d'électrode négative (40B) ;
la connexion d'un terminal de sortie de données (40C) des piles (40) et d'un enregistreur de données (50) l'un à l'autre via une ligne de communication ;
la distribution en sortie une tension à haute fréquence à la borne de sortie (T1) et la borne de mise à la terre (T2) de l'unité d'application de tension à haute fréquence (25) pendant une période de temps prédéterminée ; et
l'enregistrement, dans l'enregistreur de données (50), de données relatives à la tension des piles secondaires provenant des piles (40) pendant la période de temps prédéterminée.
